# EUROPÄISCHE PATENTSCHRIFT

(11) **EP 1 540 786 B1**
(45) Veröffentlichungstag und Bekanntmachung des Hinweises auf die Patenterteilung: **10.01.2007**
(21) Anmeldenummer: 03790845.6
(22) Anmeldetag: 01.08.2003
(51) Int. Cl.: H01S 5/14

(54) **HALBLEITERLASERVORRICHTUNG**
SEMICONDUCTOR LASER DEVICE
DISPOSITIF LASER A SEMI-CONDUCTEUR

(30) Priorität: 02.09.2002 DE 10240949; 25.10.2002 DE 10250048; 25.10.2002 DE 10250046
(43) Veröffentlichungstag der Anmeldung: 15.06.2005
(73) Patentinhaber: Hentze-Lissotschenko Patentverwaltungs GmbH & Co. KG, 36419 Gerstengrund (DE)
(72) Erfinder: MIKHAILOV, Aleksei, 44227 Dortmund (DE); HILL, Wieland, 44388 Dortmund (DE); HARTEN, Paul, Alexander, 45133 Essen (DE)
(74) Vertreter: Basfeld, Rainer
(86) Internationale Anmeldenummer: PCT/EP2003/008526
(87) Internationale Veröffentlichungsnummer: WO 2004/021525

(56) Entgegenhaltungen:
- EP-A- 0 712 183
- EP-A- 0 961 152
- US-A- 4 656 641
- US-A- 4 797 894
- US-A- 5 773 345
- US-B1- 6 404 797

## Beschreibung

Die vorliegende Erfindung betrifft eine Halbleiterlaservorrichtung gemäß dem Oberbegriff des Anspruchs 1.

Eine Halbleiterlaservorrichtung der vorgenannten Art ist aus dem US-Patent US-A-4 656 641 bekannt. Die darin beschriebene Halbleiterlaservorrichtung umfasst ein Halbleiterlaserelement mit einer Mehrzahl von Austrittsflächen für die Laserstrahlung. Halbleiterlaservorrichtung weist weiterhin einen externen Resonator auf, der einen Konkavspiegel umfasst, der beabstandet von dem Halbleiterlaserelement angeordnet ist und das Laserlicht in das Halbleiterlaserelement zurück reflektieren kann.

Eine weitere Halbleiterlaservorrichtung ist bekannt dem US-Patent US-A-6 404 797 bekannt. Die darin beschriebene Vorrichtung ist als Array von VCSEL-Laserdioden ausgeführt, bei denen die Laserstrahlung senkrecht zur aktiven Schicht aus den Laserdioden austritt. Jeder Laserdiode dieses Arrays ist jeweils ein beispielsweise als Konkav-Spiegel ausgeführter externer Reflektor zugeordnet, der Teil eines externen Resonators der Halbleiterlaservorrichtung.

Eine weitere Halbleiterlaservorrichtung ist aus I. Nelson, B. Chann, T.G. Walker, Opt. Lett. 25, 1352 (2000) bekannt. Bei der darin beschriebenen Halbleiterlaservorrichtung wird ein externer Resonator verwendet, der als Reflexionsmittel ein Gitter einsetzt. Weiterhin befindet sich in dem externen Resonator direkt anschließend an das Halbleiterlaserelement eine Fast-Axis-Kollimationslinse. Zwischen der Fast-Axis-Kollimationslinse und dem Gitter sind zwei als Teleskop dienende Linsen angeordnet. Als nachteilig bei einer derartigen Halbleiterlaservorrichtung erweist sich, dass zum einen aufgrund der vielen optischen Komponenten innerhalb des externen Resonators vergleichsweise hohe Verluste auftreten, so dass die Ausgangsleistung der Halbleiterlaservorrichtung vergleichsweise gering ist. Zum anderen kann mit der aus dem Stand der Technik bekannten Halbleiterlaservorrichtung lediglich auf die longitudinalen Moden des Halbleiterlaserelements bzw. der einzelnen Emitter des Halbleiterlaserelements Einfluss genommen werden. Durch den aus dem Stand der Technik bekannten Aufbau lässt sich das transversale Modenspektrum der Halbleiterlaservorrichtung nicht beeinflussen. Aus diesem Grund wird diese aus dem Stand der Technik bekannte Halbleiterlaservorrichtung pro Emitter eine Vielzahl von unterschiedlichen transversalen Moden aufweisen, die sämtlich zu dem von der Halbleiterlaservorrichtung ausgesandten Laserlicht beitragen. Aufgrund dieser Tatsache lässt sich das aus der Halbleiterlaservorrichtung gemäß diesem Stand der Technik austretende Laserlicht nur schwer fokussieren.

Gemäß dem Stand der Technik wird weiterhin versucht, das Modenspektrum von Halbleiterlaserelementen durch Strukturierung der aktiven Zone des Halbleiterlaserelements zu beeinflussen. Diese Strukturierungen können beispielsweise Veränderungen des Brechungsindex in verschiedenen Richtungen umfassen, so dass durch diese sich in verschiedenen Richtungen ändernden Brechungsindizes die Ausbreitung einzelner bevorzugter transversaler Lasermoden bevorzugt wird. Weiterhin besteht die Möglichkeit, beispielsweise durch unterschiedliche Dotierungsgrade auf die Anzahl der zur Rekombination zur Verfügung stehenden Elektronen-Loch-Paare einzuwirken, so dass an unterschiedlichen Stellen der aktiven Zone unterschiedliche Verstärkungen des Laserlichtes möglich sind. Beide vorgenannten Methoden zur Bevorzugung einzelner transversaler Moden sind mit beträchtlichem Fertigungsaufwand verbunden und ergeben ebenfalls keine wirklich befriedigende Strahlqualität bzw. Ausgangsleistung der Halbleiterlaservorrichtung.

Das der vorliegenden Erfindung zugrunde liegende Problem ist die Schaffung einer Halbleiterlaservorrichtung der eingangs genannten Art, die eine hohe Ausgangsleistung bei verbesserter Strahlqualität aufweist.

Dies wird erfindungsgemäß durch eine Halbleiterlaseranordnung der eingangs genannten Art mit den kennzeichnenden Merkmalen des Anspruchs 1 erreicht. Die Unteransprüche betreffen bevorzugte Ausgestaltungen der Erfindung.

Dabei weist das Reflexionsmittel eine Mehrzahl von reflektierenden Flächen auf, die voneinander verschieden sind und jeweils aus den einzelnen Austrittsflächen austretende Teilstrahlen reflektieren können

Weiterhin können die reflektierenden Flächen die entsprechenden Teilstrahlen des Laserlichtes auf die jeweiligen Austrittsflächen derart zurückreflektieren, dass diese als Apertur dienen. Durch diese Maßnahme kann mit einfachsten Mitteln Einfluss auf das Modenspektrum das Halbleiterlaserelements genommen werden.

Wie bei dem Stand der Technik kann die Halbleiterlaservorrichtung ein zwischen dem Reflexionsmittel und dem Halbleiterlaserelement oder den Einzelemittern angeordnetes Linsenmittel umfassen, das zumindestens in der ersten Richtung die Divergenz des Laserlichts zumindest teilweise verkleinern kann. Dieses Linsenmittel dient somit als Fast-Axis-Kollimationslinse.

Gemäß einer bevorzugten Ausführungsform der vorliegenden Erfindung umfasst die Halbleiterlaservorrichtung eine Strahltransformationseinheit, die insbesondere als Strahldreheinheit ausgeführt ist und vorzugsweise jeweils einzelne der Teilstrahlen drehen kann, insbesondere um etwa 90°. Mit einer derartigen Strahltransformationseinheit kann das aus der Halbleiterlaservorrichtung austretende Laserlicht derart transformiert werden, dass es anschließend leichter fokussierbar ist.

Gemäß einer bevorzugten Ausführungsform der vorliegenden Erfindung ist die Strahltransformationseinheit zwischen dem Reflexionsmittel und dem Halbleiterlaserelement oder den Einzellasern angeordnet, insbesondere zwischen dem Reflexionsmittel und dem Linsenmittel. Durch eine derartige Anordnung der Strahltransformationseinheit innerhalb des externen Resonators kann mehr Raum für die Auskopplung geschaffen werden.

Die Halbleiterlaservorrichtung kann weiterhin ein frequenzverdoppelndes Element umfassen, das zwischen dem Reflexionsmittel und dem Halbleiterlaserelement oder den Einzellasern angeordnet ist, insbesondere zwischen dem Reflexionsmittel und dem Linsenmittel. Dabei könnte insbesondere die zweite Harmonische zumindest teilweise aus der Halbleiterlaservorrichtung ausgekoppelt und die Grundwellenlänge zur Beeinflussung des Modenspektrums zumindest teilweise in das Halbleiterlaserelement oder die Einzellaser zurückreflektiert werden.

Erfindungsgemäß besteht weiterhin die Möglichkeit, dass das Halbleiterlaserelement nur in Teilbereichen, die der räumlichen Ausdehnung einer gewünschten Mode des Laserlichts entsprechen, mit Spannung beaufschlagt bzw. mit Strom zur Erzeugung von Elektronen-Loch-Paaren versorgt wird. Durch diese vergleichsweise einfach durchführbare Maßnahme kann die Bevorzugung gewünschter Moden des Laserlichts weiter optimiert werden.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine schematische Draufsicht auf ein Beispiel einer Halbleiterlaservorrichtung;
- Fig. 2: eine schematische Draufsicht auf eine Ausführungsform einer erfindungsgemäßen Halbleiterlaservorrichtung;
- Fig. 3: eine schematische Draufsicht auf eine weitere Ausführungsform einer erfindungsgemäßen Halbleiterlaservorrichtung;
- Fig. 4: eine schematische Draufsicht auf eine weitere Ausführungsform einer erfindungsgemäßen Halbleiterlaservorrichtung.

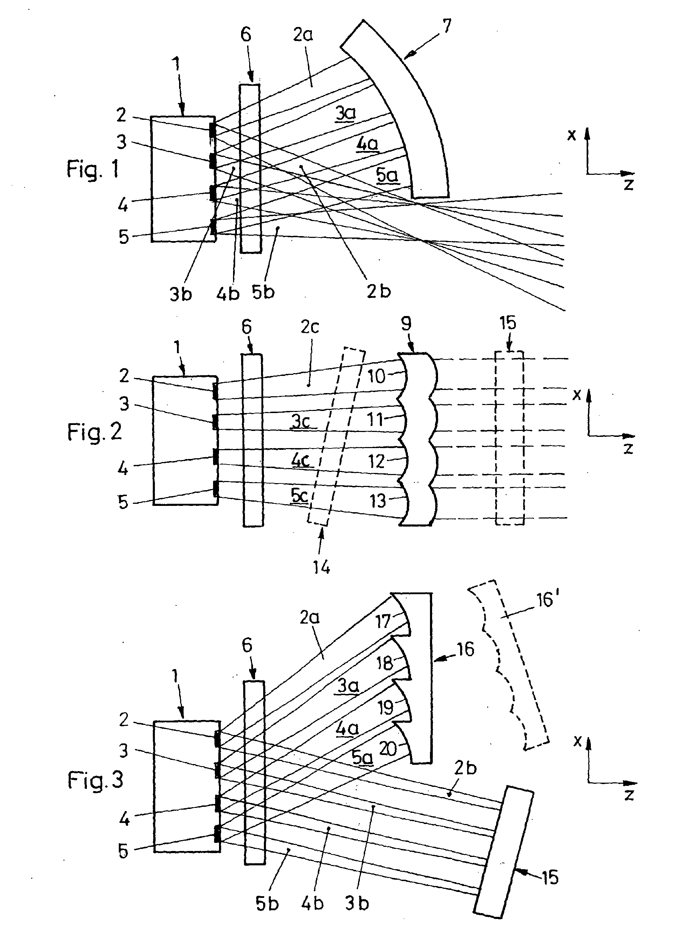

Das in Fig. 1 abgebildete Beispiel einer Halbleiterlaservorrichtung umfasst ein Halbleiterlaserelement 1 mit einer Mehrzahl von Austrittsflächen 2, 3, 4, 5, aus denen Laserlicht austreten kann. Das Halbleiterlaserelement 1 ist als Breitstreifenemitter-Array bzw. als sogenannter Laserdiodenbarren ausgeführt. In dem abgebildeten Ausführungsbeispiel sind nur vier der Lichtemissionen dienende voneinander separierte Austrittsflächen 2, 3, 4, 5 eingezeichnet. Es besteht jedoch durchaus die Möglichkeit, dass eine wesentliche größere Zahl von parallel und beabstandet zueinander angeordneten Austrittsflächen vorgesehen ist.

Das aus jeder der Austrittsflächen 2, 3, 4, 5 austretende Laserlicht ist jeweils in zwei Teilstrahlen 2a, 2b; 3a, 3b; 4a, 4b; 5a, 5b aufgespalten, die jeweils mit der Normalen auf den Austrittsflächen 2, 3, 4, 5 einen entgegengesetzt gleichen Winkel einschließen. Die beiden jeweils zusammengehörigen Teilstrahlen 2a, 2b; 3a, 3b; 4a, 4b; 5a, 5b repräsentieren jeweils eine herausgegriffene Laser-Mode des zu der entsprechenden Austrittsfläche 2, 3, 4, 5 gehörigen emittierenden Teilbereichs des Halbleiterlaserelements 1.

Wie aus Fig. 1 ersichtlich ist, umfasst eine Halbleiterlaservorrichtung weiterhin außerhalb des Halbleiterlaserelements 1 ein Linsenmittel 6, das als Fast-Axis-Kollimationslinse ausgebildet ist. Die Fast-Axis entspricht in dem eingezeichneten kartesischen Koordinatensystem der Y-Richtung. Die Fast-Axis ist bei derartigen Breitstreifenemittern die Richtung senkrecht zu der Richtung, in denen die Einzelemitter nebeneinander angeordnet sind. Die Divergenz eines derartigen Halbleiterlaserelements 1 in der Fast-Axis ist wesentlich größer als in der dazu senkrechten Slow-Axis, die in Fig. 1 der X-Richtung entspricht.

Hinter dem Linsenmittel 6 ist in geeigneter Entfernung von dem Halbleiterlaserelement 1 ein Reflexionsmittel 7 mit einer dem Halbleiterlaserelement 1 zugewandten reflektierenden Fläche 8 angeordnet. Von der reflektierenden Fläche 8 werden die Teilstrahlen 2a, 3a, 4a, 5a in Richtung auf die Austrittsflächen 2, 3, 4, 5 zurückreflektiert. Die Austrittsflächen 2, 3, 4, 5 sind gegebenenfalls mit einer entspiegelnden Beschichtung versehen, so dass die zurückreflektierten Teilstrahlen 2a, 3a, 4a, 5a zumindest teilweise derart in das Halbleiterlaserelement 1 eindringen können, dass dadurch das Modenspektrum des Halbleiterlaserelements 1 beeinflusst wird. Insbesondere kann je nach Ausrichtung, Brennweite und Abstand des Reflexionsmittels 7 hinsichtlich der Austrittsflächen 2, 3, 4, 5 die Ausbreitung bestimmter Moden in dem Halbleiterlaserelement 1 bevorzugt werden. Bei der in Fig. 1 abgebildeten Ausführungsform einer erfindungsgemäßen Halbleiterlaservorrichtung werden in der Regel nicht alle Laseremitter, die den einzelnen Austrittsflächen 2, 3, 4, 5 zugeordnet sind, auf der gleichen Mode oszillieren, weil die Winkel, unter denen die eingezeichneten Teilstrahlen 2a, 3a, 4a, 5a aus den Austrittsflächen 2, 3, 4, 5 austreten, etwas unterschiedlich sind.

Der Abstand der reflektierenden Fläche 8 von den Austrittsflächen 2, 3, 4, 5 kann so gewählt werden, dass er im wesentlichen der Brennweite der reflektierenden Fläche 8 entspricht. Insbesondere kann durch entsprechende Wahl des Abstands bzw. der Brennweite die Strahltaille auf den Austrittsflächen 2, 3, 4, 5 etwa deren jeweiliger Breite entsprechen.

Die Auskopplung aus der Halbleiterlaservorrichtung gemäß Fig.1 kann über die Teilstrahlen 2b, 3b, 4b, 5b erfolgen. Beispielsweise könnte in Fig. 1 unterhalb des Reflexionsmittels 7 ein weiteres teilreflektierendes Reflexionsmittel eingefügt werden, das als Auskoppler dient. Zusätzlich oder alternativ dazu könnte auch in den Strahlengang der Teilstrahlen 2b, 3b, 4b, 5b eine Strahltransformationseinheit eingebracht werden, die die weitere Verarbeitung der ausgekoppelten Teilstrahlen erleichtert.

Bei der in Fig. 2 abgebildeten Ausführungsform einer erfindungsgemäßen Halbleiterlaservorrichtung sind gleiche Teile mit gleichen Bezugszeichen versehen. In Fig. 2 sind Teilstrahlen 2c, 3c, 4c, 5c eingezeichnet, die einer transversalen Mode der einzelnen Emitter des Halbleiterlaserelements 1 entsprechen, die im wesentlichen parallel zu der Normalen auf den Austrittsflächen 2, 3, 4, 5, d. h. etwa in Z-Richtung gemäß dem kartesischen Koordinatensystem, aus dem Halbleiterlaserelement 1 austritt. Das in Fig. 2 vorgesehene Reflexionsmittel 9 weist nicht nur eine reflektierende Fläche, sondern eine Mehrzahl von reflektierenden Flächen 10, 11, 12, 13 auf. Somit ist jedem der Teilstrahlen 2c, 3c, 4c, 5c eine der reflektierenden Flächen 10, 11, 12, 13 zugeordnet, so dass bei dieser Ausführungsform jeder der den Austrittsflächen 2, 3, 4, 5 entsprechenden Emitter des Halbleiterlaserelements 1 in der gleichen transversalen bzw. longitudinalen Mode betrieben werden kann.

Zur Bevorzugung einer einzelnen longitudinalen Mode ist in Fig. 2 gestrichelt ein wellenselektives Element 14 eingezeichnet, das beispielsweise als Etalon ausgeführt sein kann. Durch das optionale wellenselektives Element 14 besteht die Möglichkeit, bestimmte longitudinale Moden, insbesondere eine longitudinale Mode auszuwählen, so dass das ausgesandte Laserlicht eine geringe spektrale Breite aufweist.

Die Auskopplung aus der Halbleiterlaservorrichtung kann entweder dadurch erzielt werden, dass das Reflexionsmittel 9 teilreflektierend ausgebildet ist, so dass in positiver Z-Richtung aus dem Reflexionsmittel 9 Laserlicht austreten kann. Alternativ dazu kann die Seite des Halbleiterlaserelements, die von dem durch das Reflexionsmittel 9 gebildeten externen Resonator abgewandt ist, teilweise entspiegelt sein oder nicht hochreflektierend sein, so dass auf der linken Seite in Fig. 2 des Halbleiterlaserelements Laserlicht in die negative Z-Richtung austreten kann.

Gemäß einer weiteren Alternative besteht die Möglichkeit , dass in Fig. 2 links von dem Halbleiterlaserelement 1 ein weiteres, dem Reflexionsmittel 9 gleichendes Reflexionsmittel angeordnet ist, das das aus dem Halbleiterlaserelement 1 in negativer Z-Richtung austretende Laserlicht in das Halbleiterlaserelement 1 zurückreflektieren kann. Der externe Resonator wird in diesem Fall durch die beiden Reflexionsmittel 9 gebildet, deren reflektierende Flächen einander zugewandt sind. Eines der Reflexionsmittel 9 kann dabei teilreflektierend ausgebildet sein, so dass das Laserlicht durch dieses Reflexionsmittel teilweise zur Auskopplung hindurchtreten kann.

In Fig. 2 ist weiterhin auf der rechten Seite des Reflexionsmittels eine Strahltransformationseinheit 15 gestrichelt eingezeichnet, die bei Lichtaustritt in positiver Z-Richtung aus dem Reflexionsmittel 9 den Strahl transformieren kann. Es kann sich bei der Strahltransformationseinheit beispielsweise um eine Strahldreheinheit handeln, die jeden der Teilstrahlen 2c, 3c, 4c, 5c einzeln um beispielsweise 90° drehen kann. Durch eine derartige Strahltransformation wird die Fokussierbarkeit des austretenden Laserlichts verbessert. Es besteht erfindungsgemäß durchaus die Möglichkeit, eine derartige Strahltransformationseinheit auch bei der Ausführungsform gemäß Fig. 1 zu verwenden.

Die Halbleiterlaservorrichtung gemäß Fig. 3 unterscheidet sich von derjenigen in Fig. 2 im wesentlichen dadurch, dass Moden bevorzugt werden, die entsprechend Fig. 1 unter einem Winkel zur Normalen aus den Austrittsflächen 2, 3, 4, 5 austreten. Das bei der Halbleiterlaservorrichtung gemäß Fig. 3 vorgesehene Reflexionsmittel 16 weist wiederum eine Vielzahl von reflektierenden Flächen 17, 18, 19, 20 auf. Bei der durchgezogen eingezeichneten Ausführungsform des Reflexionsmittels 16 ist dieses im wesentlichen parallel zur X-Richtung orientiert, so dass die Wege der einzelnen Teilstrahlen 2a, 3a, 4a, 5a zwischen den Austrittsflächen 2, 3, 4, 5 und den reflektierenden Flächen 17, 18, 19, 20 gleich sind. Alternativ dazu kann auch ein Reflexionsmittel 16' vorgesehen sein, das in Fig. 3 strichpunktiert eingezeichnet ist und an der gleichen Stelle in die Halbleiterlaservorrichtung eingebaut sein kann, wie das Reflexionsmittel 16. Für ein derartiges Reflexionsmittel 16', das im wesentlichen senkrecht zur Ausbreitungsrichtung der Teilstrahlen 2a, 3a, 4a, 5a ausgerichtet ist, sind die optischen Wege der Teilstrahlen 2a, 3a, 4a, 5a zwischen den Austrittsflächen 2, 3, 4, 5 und dem Reflexionsmittel 16' verschieden.

Bei dem Reflexionsmittel 16 sind die einzelnen reflektierenden Flächen 17, 18, 19, 20 gegenüber der Z-Achse geneigt. Dies entfällt bei dem Reflexionsmittel 16'. Allerdings kann es bei diesem erforderlich sein, die Krümmungsradien der reflektierenden Flächen jeweils unterschiedlich zu gestalten.

In Fig. 3 ist ebenfalls eine Strahltransformationseinheit 15 eingezeichnet, die in den auszukoppelnden Strahlen 2b, 3b, 4b, 5b angeordnet ist. Das durch diese Strahltransformationseinheit 15 hindurchtretende Laserlicht kann beispielsweise durch weitere Fokussiermittel auf das Ende einer Glasfaser fokussiert werden.

Es besteht die Möglichkeit, auch bei den Ausführungsformen gemäß Fig. 1 und Fig. 3 ein wellenlängenselektives Element vorzusehen. Dies könnte bei den unterschiedlich geneigten Teilstrahlen gemäß Fig. 1 ein gekrümmtes Etalon erforderlich machen, um jeweils die gleiche Wellenlänge zu selektieren.

Erfindungsgemäß besteht weiterhin die Möglichkeit, eine Strahltransformationseinheit in dem externen Resonator, d. h. zwischen dem jeweiligen Reflexionsmittel 7, 9, 16, 16' und dem Halbleiterlaserelement 1, insbesondere zwischen dem Linsenmittel 6 und dem Reflexionsmittel 7, 9, 16, 16' anzuordnen. Eine derartige Anordnung kann unter Umständen den Vorteil mit sich bringen, dass dadurch mehr Raum für die Auskopplung geschaffen wird.

Eine beispielsweise als Strahldreheinheit ausgeführte Strahltransformationseinheit dreht die Emission der einzelnen Emitter um 90°. Nach einer derartigen Drehung laufen die Teilstrahlen 2a, 3a, 4a, 5a unter gleichen Winkeln zur X-Z-Ebene nach oben und die Teilstrahlen 2b, 3b, 4b, 5b unter entgegengesetzt gleichen Winkeln nach unten. Zur Slow-Axis-Kollimation ist dann ein einzelner Zylinderspiegel geeignet. Wenn sphärische Spiegel eingesetzt werden sollen, braucht man für die Slow-Axis-Kollimation in diesem Fall weiter ein Spiegelarray.

Falls ein Stack von Emitterarrays benutzt wird, könnte man bei einem Aufbau mit einer Strahldreheinheit ein eindimensionales Array aus Zylinderspiegeln für die Slow-Axis-Kollimation benutzen.

Erfindungsgemäß besteht weiterhin die Möglichkeit, ein frequenzverdoppelndes Element, beispielsweise einen frequenzverdoppelnden Kristall in dem externen Resonator unterzubringen. Beispielsweise könnte dieses Element zwischen dem Linsenmittel 6 und dem Reflexionsmittel 9 in Fig. 2 untergebracht werden. In diesem Fall können die reflektierenden Flächen 10, 11, 12, 13 hoch reflektierend für die Grundwellenlänge und durchlässig für die Wellenlänge der zweiten Harmonischen sein. Unter Umständen könnte dabei das Linsenmittel 6 derart gestaltet werden, dass die Grundwellenlänge ungehindert durchgelassen wird und die zweite Harmonische reflektiert wird, so dass die zweite Harmonische nicht in das Halbleiterlaserelement 1 zurückgekoppelt wird.

Es besteht erfindungsgemäß die Möglichkeit, als Halbleiterlaserelement 1 ein Stack von Emitterarrays zu verwenden. In diesem Fall kann beispielsweise ein zweidimensionales Array von sphärischen oder zylindrischen Spiegeln oder ein eindimensionales Array von zylindrischen Spiegeln genutzt werden. Hierbei können der Abstand und die Brennweite entsprechend den Ausführungen zu Fig. 1 bestimmt werden.

Es besteht weiterhin die Möglichkeit, anstelle eines als Laserdiodenbarren ausgeführten Halbleiterlaserelements 1 eine Mehrzahl von separaten, parallel montierten Einzellasern zu verwenden. Diese könnten als Single-Mode-Laser betrieben werden und einzeln angesteuert werden. Eine derartige Mehrzahl von Einzellasern eignet sich insbesondere für Anwendungen in der Medizintechnik.

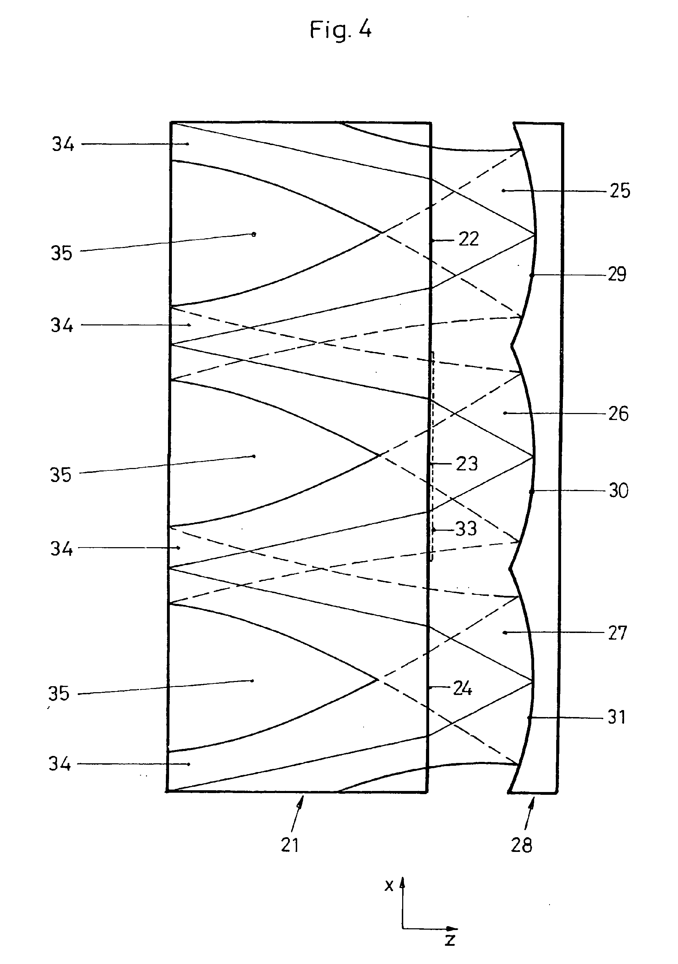

Aus Fig. 4 ist ein Halbleiterlaserelement 21 ersichtlich, dass als Laserdiodenbarren ausgeführt ist. Das Halbleiterlaserelement 21 weist eine Vielzahl von Austrittsflächen 22, 23, 24 auf, aus denen Laserlicht 25, 26, 27 austreten kann. Weiterhin ist bei der Ausführungsform gemäß Fig. 4 ein Reflexionsmittel 28 vorgesehen, dass eine Vielzahl von nebeneinander angeordneten reflektierenden Flächen 29, 30, 31 aufweist, die beispielsweise wie die reflektierenden Fläche 10, 11, 12, 13 gemäß Fig. 2 ausgebildet sind. Wie bei dem Ausführungsbeispiel gemäß Fig. 2 wird auch von den reflektierenden Flächen 29, 30, 31 der entsprechenden Anteil des Laserlichtes 25, 26, 27 durch die zugehörigen Austrittsflächen 22, 23, 24 in das Halbleiterlaserelement 21 zurückreflektiert. Bei der in Fig. 4 abgebildeten selektierten Mode des Laserlichtes werden von jeder der reflektierenden Flächen 29, 30, 31 Teilstrahlen des jeweiligen Laserlichtes 25, 26, 27 derart in das Halbleiterlaserelement 21 zurückreflektiert, dass sie unter einem Winkel zur Normalen an der gegenüberliegenden Endfläche 32 des Halbleiterlaserelements reflektiert werden, so dass sie nach dieser Reflexion aus der benachbarten Austrittsfläche 22, 23, 24 austreten. Auf diese Weise kann erreicht werden, dass sich in dem gesamten Halbleiterlaserelement 21 im wesentlichen eine einzige Mode des Laserlichtes ausbildet.

Es kann beispielsweise auch vorgesehen sein, dass einzelne Austrittsflächen, wie beispielhaft die in Fig. 4 mittlere Austrittsfläche 23 mit einer hoch reflektierenden Beschichtung 33 versehen ist, so dass aus dieser Austrittsfläche 23 kein Licht aus dem Halbleiterlaserelement austreten kann. Das Licht wird in diesem Falle an dieser Austrittsfläche reflektiert und tritt nach weiterer Reflexion an der gegenüberliegenden Endfläche 32 durch eine der benachbarten Austrittsflächen 22, 24 aus dem Halbleiterlaserelement 21 aus.

Bei der Ausführungsform gemäß Fig. 4 kann vorgesehen sein, dass nur bestimmte Teilbereiche 34 des Halbleiterlaserelements 21 mit Elektroden versehen sind, so dass nur diese Teilbereiche 34 mit Spannung beaufschlagt werden und damit nur in diesen Teilbereichen 34 Strom zugeführt wird zur Erzeugung von Elektronen-Loch-Paaren. In Fig. 4 sind weiterhin Teilbereiche 35 eingezeichnet, die nicht mit Elektroden versehen sind und demgemäß auch nicht mit Spannung beaufschlagt werden können. Durch eine derartige Gestaltung wird die Ausbildung einer oder mehrerer bevorzugter Moden optimiert. Es besteht die Möglichkeit, zwischen Reflexionsmittel 28 und Halbleiterlaserelement 21 ein in Fig. 4 nicht eingezeichnetes Linsenmittel anzuordnen.

## Patentansprüche

1. Halbleiterlaservorrichtung umfassend
- ein Halbleiterlaserelement (1, 21) oder eine Mehrzahl von parallel montierten Einzellasern mit einer Mehrzahl von Austrittsflächen (2, 3, 4, 5, 22, 23, 24), aus denen im Betrieb des Vorrichtung Laserlicht austritt, das in einer ersten Richtung (Y) eine größere Divergenz aufweist, als in einer dazu senkrechten zweiten Richtung; sowie
- mindestens ein beabstandet zu den Austrittsflächen (2, 3, 4, 5, 22, 23, 24) außerhalb des Halbleiterlaserelements (1) oder der Einzellaser angeordnetes Reflexionsmittel (7, 9, 16, 16', 28) mit mindestens einer konkav gekrümmten reflektierenden Fläche (8, 10, 11, 12, 13, 17, 18, 19, 20, 29, 30, 31), die im Betrieb der Vorrichtung zumindest Teile des aus dem Halbleiterlaserelements (1, 21) oder den Einzellasern durch die Austrittsflächen (2, 3, 4, 5, 22, 23, 24) ausgetretenen Laserlichts derart in das Halbleiterlaserelement (1, 21) oder die Einzellaser zurückreflektiert, dass **dadurch** das Modenspektrum des Halbleiterlaserelements (1, 21) oder der Einzellaser beeinflusst wird;
**dadurch gekennzeichnet, dass**
- das Reflexionsmittel (9, 16, 16', 28) eine Mehrzahl von reflektierenden Einzelflächen (10, 11, 12, 13, 17, 18, 19, 20, 29, 30, 31) aufweist, die jeweils einen der aus den einzelnen Austrittsflächen (2, 3, 4, 5, 22, 23, 24) austretende Teilstrahlen (2a, 2c; 3a, 3c; 4a, 4c; 5a, 5c) reflektieren.

2. Halbleiterlaservorrichtung nach Anspruch 1, **dadurch gekennzeichnet, dass** die reflektierenden Flächen (8, 10, 11, 12, 13, 17, 18, 19, 20, 29, 30, 31) Teilstrahlen des Laserlichts derart auf die Austrittsflächen (2, 3, 4, 5, 22, 23, 24) zurückreflektieren können, dass diese als Apertur dienen.

3. Halbleiterlaservorrichtung nach einem der Ansprüche 1 oder 2, **dadurch gekennzeichnet, dass** die Halbleiterlaservorrichtung ein zwischen dem Reflexionsmittel (7, 9, 16, 16', 28) und dem Halbleiterlaserelement (1, 21) oder den Einzellasern angeordnetes Linsenmittel (6) umfasst, das zumindestens in der ersten Richtung (Y) die Divergenz des Laserlichts zumindest teilweise verkleinern kann.

4. Halbleiterlaservorrichtung nach einem der Ansprüche 1 bis 3, **dadurch gekennzeichnet, dass** die Halbleiterlaservorrichtung eine Strahltransformationseinheit (15) umfasst, die insbesondere als Strahldreheinheit ausgeführt ist und vorzugsweise jeweils einzelne der Teilstrahlen (2a, 2b, 2c; 3a, 3b, 3c; 4a, 4b, 4c; 5a, 5b, 5c) drehen kann, insbesondere um etwa 90°.

5. Halbleiterlaservorrichtung nach Anspruch 4, **dadurch gekennzeichnet, dass** die Strahltransformationseinheit (15) zwischen dem Reflexionsmittel (7, 9, 16, 16', 28) und dem Halbleiterlaserelement (1) oder den Einzellasern angeordnet ist, insbesondere zwischen dem Reflexionsmittel (7, 9, 16, 16') und dem Linsenmittel (6).

6. Halbleiterlaservorrichtung nach einem der Ansprüche 1 bis 5, **dadurch gekennzeichnet, dass** die Halbleiterlaservorrichtung weiterhin ein frequenzverdoppelndes Element umfasst, das zwischen dem Reflexionsmittel (7, 9, 16, 16', 28) und dem Halbleiterlaserelement (1, 21) oder den Einzellasern angeordnet ist, insbesondere zwischen dem Reflexionsmittel (7, 9, 16, 16', 28) und dem Linsenmittel (6).

7. Halbleiterlaservorrichtung nach einem der Ansprüche 1 bis 6, **dadurch gekennzeichnet, dass** das Halbleiterlaserelement (21) nur in Teilbereichen (34), die der räumlichen Ausdehnung einer gewünschten Mode des Laserlichts entsprechen, mit Spannung beaufschlagt bzw. mit Strom zur Erzeugung von Elektronen-Loch-Paaren versorgt wird.

## Claims

1. Semiconductor laser device comprising
- a semiconductor laser element (1, 21), or a plurality of individual lasers mounted in parallel, having a plurality of emission surfaces (2, 3, 4, 5, 22, 23, 24) out of which, during operation of the device, laser light is emitted that has a larger divergence in a first direction (Y) than in a second direction orthogonal to this; and
- at least one reflection means (7, 9, 16, 16', 28) arranged outside the semiconductor laser element (1) or the individual lasers at a distance from the emission surfaces (2, 3, 4, 5, 22, 23, 24) having at least one reflecting surface (8, 10, 11, 12, 13, 17, 18, 19, 20, 29, 30, 31) of concave curvature, which, during operation of the device, reflects at least parts of the laser light emitted from the semiconductor laser element (1, 21) or the individual lasers through the emission surfaces (2, 3, 4, 5, 22, 23, 24) back into the semiconductor laser element (1, 21) or the individual lasers in such a way that the mode spectrum of the semiconductor laser element (1, 21) or the individual lasers is affected thereby;
**characterized in that**
- the reflection means (9, 16, 16', 28) comprises a plurality of individual reflecting surfaces (10, 11, 12, 13, 17, 18, 19, 20, 29, 30, 31), each of which reflect one of the sub-beams (2a, 2c; 3a, 3c; 4a, 4c; 5a, 5c) being emitted from the individual emission surfaces (2, 3, 4, 5, 22, 23, 24).

2. Semiconductor laser device according to Claim 1, **characterized in that** the reflecting surfaces (8, 10, 11, 12, 13, 17, 18, 19, 20, 29, 30, 31) can reflect sub-beams of the laser light back onto the emission surfaces (2, 3, 4, 5, 22, 23, 24) in such a way that these surfaces act as an aperture.

3. Semiconductor laser device according to either of Claims 1 or 2, **characterized in that** the semiconductor laser device comprises a lens means (6) arranged between the reflection means (7, 9, 16, 16', 28) and the semiconductor laser element (1, 21) or the individual lasers, which can reduce at least partially the divergence of the laser light at least in the first direction (Y).

4. Semiconductor laser device according to any of Claims 1 to 3, **characterized in that** the semiconductor laser device comprises a beam transformation unit (15), which is designed in particular as a beam rotation unit and preferably can rotate in each case individual sub-beams (2a, 2b, 2c; 3a, 3b, 3c; 4a, 4b, 4c; 5a, 5b, 5c), in particular through approximately 90°.

5. Semiconductor laser device according to Claim 4, **characterized in that** the beam transformation unit (15) is arranged between the reflection means (7, 9, 16, 16', 28) and the semiconductor laser element (1) or the individual lasers, in particular between the reflection means (7, 9, 16, 16') and the lens means (6).

6. Semiconductor laser device according to any of Claims 1 to 5, **characterized in that** the semiconductor laser device also comprises a frequency doubling element, which is arranged between the reflection means (7, 9, 16, 16', 28) and the semiconductor laser element (1, 21) or the individual lasers, in particular between the reflection means (7, 9, 16, 16', 28) and the lens means (6).

7. Semiconductor laser device according to any of Claims 1 to 6, **characterized in that** a voltage is applied, or more precisely a current for generating electron-hole pairs is supplied, to the semiconductor laser element (21) only in subregions (34) that correspond to the spatial extent of a required mode of the laser light.

## Revendications

1. Dispositif laser à semi-conducteur qui comprend :
- un élément laser (1, 21) à semi-conducteur ou plusieurs lasers individuels montés en parallèle et qui présentent plusieurs surfaces de sortie (2, 3, 4, 5, 22, 23, 24) desquelles de la lumière laser sort lorsque le dispositif est en fonctionnement et qui présentent une plus grande divergence dans une première direction (Y) que dans une deuxième direction perpendiculaire à la première, ainsi que
- au moins un moyen réfléchissant (7, 9, 16, 16', 28) qui présente au moins une surface réfléchissante à courbure concave (8, 10, 11, 12, 13, 17, 18, 19, 20, 29, 30, 31) et disposé à distance des surfaces de sortie (2, 3, 4, 5, 22, 23, 24) à l'extérieur de l'élément laser (1) à semi-conducteur ou des lasers individuels, et lorsque le dispositif est en fonctionnement, ses surfaces réfléchissantes réfléchissent dans l'élément laser (1, 21) à semi-conducteur ou dans les lasers individuels au moins une partie de la lumière laser sortie de l'élément laser (1, 21) à semi-conducteur ou des lasers individuels par les surfaces de sortie (2, 3, 4, 5, 22, 23, 24), de telle sorte que le spectre de mode de l'élément laser (1, 21) à semi-conducteur ou des lasers individuels soit influencé,
**caractérisé en ce que**
- les moyens réfléchissants (9, 16, 16', 28) présentent plusieurs surfaces réfléchissantes individuelles (10, 11, 12, 13, 17, 18, 19, 20, 29, 30, 31) qui réfléchissent chacune l'un des rayons partiels (2a, 2c; 3a, 3c; 4a, 4c; 5a, 5c) qui sortent par les surfaces de sortie individuelles (2, 3, 4, 5, 22, 23, 24).

2. Dispositif laser à semi-conducteur selon la revendication 1, **caractérisé en ce que** les surfaces réfléchissantes (8, 10, 11, 12, 13, 17, 18, 19, 20, 29, 30, 31) peuvent réfléchir une partie des rayons de lumière laser sur les surfaces de sortie (2, 3, 4, 5, 22, 23, 24) pour que celles-ci servent d'ouverture.

3. Dispositif laser à semi-conducteur selon l'une des revendications 1 ou 2, **caractérisé en ce que** le dispositif laser à semi-conducteur comprend un moyen à lentille (6) disposé entre les moyens réfléchissants (7, 9, 16, 16', 28) et l'élément laser (1, 21) à semi-conducteur ou les lasers individuels et qui peut diminuer au moins en partie la divergence de la lumière laser au moins dans la première direction (Y).

4. Dispositif laser à semi-conducteur selon l'une des revendications 1 à 3, **caractérisé en ce que** le dispositif laser à semi-conducteur comprend une unité (15) de transformation des faisceaux qui est réalisée en particulier sous la forme d'unité de rotation des faisceaux et qui peut tourner de préférence chacun des rayons partiels (2a, 2b, 2c; 3a, 3b, 3c; 4a, 4b, 4c; 5a, 5b, 5c) en particulier d'environ 90°.

5. Dispositif laser à semi-conducteur selon la revendication 4, **caractérisé en ce que** l'unité (15) de transformation des faisceaux est disposée entre les moyens réfléchissants (7, 9, 16, 16', 28) et l'élément laser (1) à semi-conducteur ou les lasers individuels, en particulier entre les moyens réfléchissants (7, 9, 16, 16') et le moyen à lentille (6).

6. Dispositif laser à semi-conducteur selon l'une des revendications 1 à 5, **caractérisé en ce que** le dispositif laser à semi-conducteur comprend en outre un élément de doublement de la fréquence qui est disposé entre les moyens réfléchissants (7, 9, 16, 16', 28) et l'élément laser (1, 21)) à semi-conducteur ou les lasers individuels et en particulier entre les moyens réfléchissants (7, 9, 16, 16', 28) et le moyen à lentille (6).

7. Dispositif laser à semi-conducteur selon l'une des revendications 1 à 6, **caractérisé en ce que** l'élément laser (21) à semi-conducteur est sollicité par une tension ou alimenté en courant pour créer des paires électron-trou uniquement dans les parties (34) qui correspondent à l'extension spatiale d'un mode souhaité de la lumière laser.
